## Europäisches Patentamt
## European Patent Office
## Office européen des brevets

(11) Numéro de publication: **0 032 335**
**A1**

(12) ## DEMANDE DE BREVET EUROPEEN

(21) Numéro de dépôt: **80401809.1**

(22) Date de dépôt: **17.12.80**

(51) Int. Cl.³: **H 02 M 7/537**
**H 03 F 3/217, H 03 B 11/10**

(30) Priorité: **04.01.80 FR 8000169**

(43) Date de publication de la demande:
**22.07.81 Bulletin 81/29**

(84) Etats contractants désignés:
**DE GB IT NL**

(71) Demandeur: **THOMSON-CSF**
**173, Boulevard Haussmann**
**F-75360 Paris Cedex 08(FR)**

(72) Inventeur: **Cord'homme, Edmond**
**THOMSON-CSF SCPI 173, bld Haussmann**
**F-75360 Paris Cedex 08(FR)**

(74) Mandataire: **Wang, Pierre et al,**
**"THOMSON-CSF" - SCPI 173, bld. Haussmann**
**F-75360 Paris Cedex 08(FR)**

(54) Générateur de signaux électriques à puissance élevée.

(57) Générateur de signaux électriques à des puissances pouvant atteindre plusieurs dizaines de kW notamment pour signaux sinusoïdaux, jusqu'à plusieurs dizaines de kHz.

Le générateur piloté par le signal à reproduire e(t) comprend en série avec une charge de sortie (4) un circuit à découpage (2) et au moins un circuit (3) fournissant des créneaux de courant $i_3$ dans la charge (4) pendant les temps pour lesquels e(t) > S et e(t) < -S, où S est une tension de seuil. Le circuit à découpage (2) fournit des impulsions de tension rectangulaires de largeur proportionnelle à la différence entre le signal e(t) et un signal de contre-réaction provenant de la boucle de sortie. Le circuit à découpage (2) fournit après filtrage un signal $i_2$ qui s'ajoute à $i_3$ pour donner le courant it.

Application à un générateur pour sonar à puissance et fréquence variable.

FIG_2

1

GENERATEUR DE SIGNAUX ELECTRIQUES A PUISSANCE ELEVEE.

L'objet de la présente invention est un générateur de signaux électriques à puissance élevée. Ce générateur pouvant fournir des signaux sinusoïdaux ou des signaux modulés en fréquence pour des fréquences pouvant atteindre plusieurs dizaines de kilohertz.

Les signaux fournis par un tel générateur peuvent être appliqués à des transducteurs électro-acoustiques, en particulier pour l'émission de signaux sonar, la puissance pouvant atteindre plusieurs dizaines de kilowatts. Pour ces puissances élevées il est important que le rendement soit élevé, de l'ordre de 90%, pour minimiser les volumes et poids des alimentations et pour simplifier les problèmes de refroidissement. Pratiquement il est généralement nécessaire que ces générateurs soient accordables en fréquence sur plusieurs octaves, que leur puissance puisse varier d'un facteur de 10 et que les distorsions du signal fourni soient inférieures à 5 %.

Il est connu d'utiliser pour générer des signaux électriques de grande puissance, des dispositifs comportant des amplificateurs de puissance, fonctionnant en classe D. Ce type d'amplificateurs utilise des éléments actifs, tubes ou transistors, fonctionnant en régime de commutation.

Des trains d'impulsions rectangulaires de durée variable sont obtenues par commutation d'éléments actifs à partir d'une source de tension continue, la durée des impulsions étant proportionnelle à l'amplitude d'un signal de référence. De nombreux circuits utilisant cette technique dite "à découpage" ont été développés depuis 1955 et on peut se référer aux articles de D.PASQUIER paru dans "TOUTE L'ELECTRONIQUE", Janvier-Février 1968 ; et de N. CROWBURST paru dans "RADIO-ELECTRONICS",

2

Juillet 1965.

Cette technique de découpage permet de fournir des signaux de faible distorsion dans une grande bande passante, pour une variation d'amplitude importante, à condition d'utiliser une fréquence de découpage suffisamment grande.

Par contre la technique de découpage présente l'inconvénient d'un rendement inférieur à 80 %, à cause du grand nombre des commutations. Ces commutations à forte puissance produisent en plus des perturbations parasites rayonnées importantes, qui sont souvent gênantes.

Le générateur selon l'invention permet de remédier aux inconvénients de cette technique et en particulier d'obtenir un rendement voisin de 90 %, avec des rayonnements parasites réduits fortement par rapport à l'art antérieur.

Le générateur suivant l'invention comprend d'une part un amplificateur à découpage et d'autre part au moins un amplificateur tel, qu'il fournit un courant continu pendant une durée égale à l'intervalle de temps séparant deux passages du signal de référence à une amplitude préétablie. Ce dernier type d'"amplificateur à créneau" appelé par la suite "circuit à créneau" est connu notamment par le brevet U.S. de W.Mac MURRAY n° 3,581,212 publié le 25 Mai 1971.

Brièvement c'est un générateur de signaux électriques 1 fournissant une puissance pouvant atteindre plusieurs dizaines de kilowatts à une charge 4, piloté par un signal de forme $e(t)$, $t$ étant le temps, le courant dans la charge 4 étant sensiblement proportionnelle au signal pilote $e(t)$, $e(t)$ pouvant être une sinusoïde de fréquence pouvant atteindre plusieurs dizaines de kHz et comportant un circuit 2 fournissant à la charge 4 des impulsions rectangulaires de largeur variable, ce circuit étant appelé circuit à découpage, caractérisé par le fait que ce générateur comporte en outre n circuits appelés circuits à créneau, 3.1, 3.2, ...,3.n, où n est un entier supérieur ou égal à 1, chacun des circuits à créneau fournissant des créneaux de courant à la charge 4 et qu'un circuit 20 fournit des tensions de seuil réglables $S_1$, $S_2$, ... , $S_n$, que des comparateurs comparent le signal e(t) aux seuils $S_1$, $S_2$, ..., $S_n$, commandant la conduction et le blocage d'éléments actifs dans les circuits à créneau 3.1, 3.2,...,3.n et que des sources de tension continue dans chacun de ces circuits fournissent des courants à la charge 4 dans un sens positif, si $é(t) > S_i$ et un courant dans le sens négatif si $e(t) < -S_i$ et que le circuit à découpage 2 fournit à la charge des impulsions de courant de largeur proportionnelle à la différence du signal pilote et d'un signal égal à la somme des tensions de seuil des circuits à créneau 3.1, 3.2,...,3.n en fonction.

D'autres caractéristiques et avantages ressortiront de la description qui va suivre donnée à titre d'exemple et illustrée par les figures qui représentent :

- la figure 1, un schéma général du générateur suivant l'invention ;

- la figure 2, le schéma d'un exemple de réalisation de l'invention comprenant un circuit à découpage et un "circuit à créneau" ;

- la figure 3, les signaux temporels de commutation du circuit à découpage et du circuit à créneau ;

- la figure 4, les signaux temporels des courants fournis par le générateur suivant l'invention ;

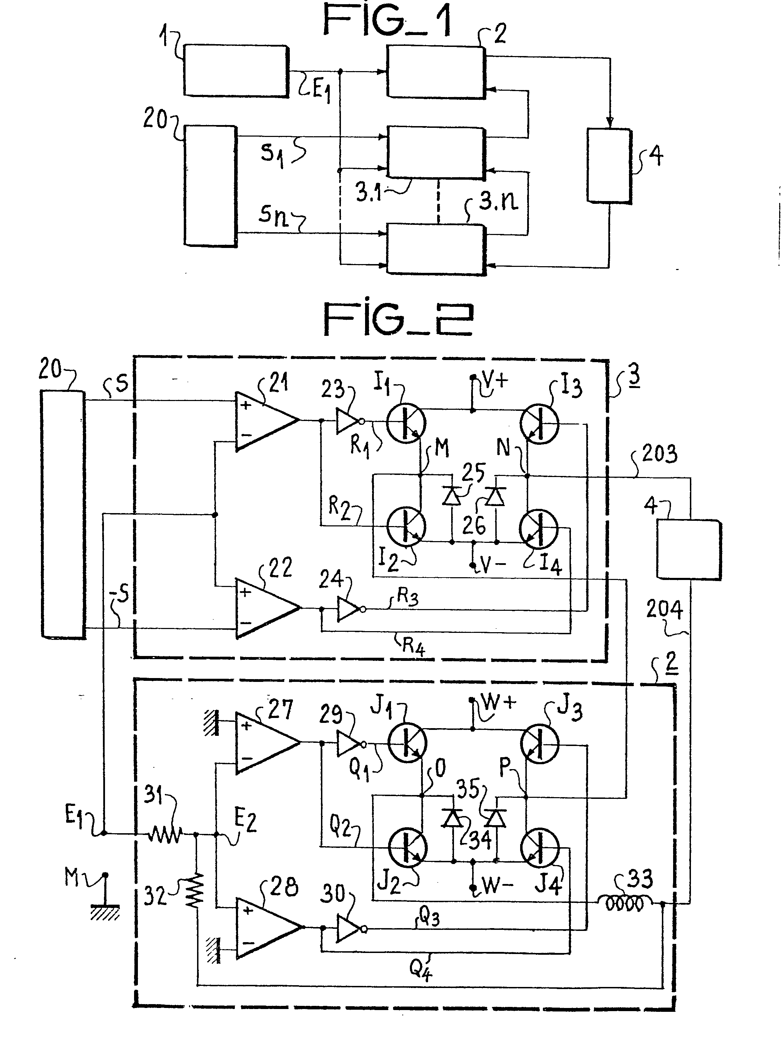

La figure 1, montre un schéma général d'un générateur, suivant l'invention. Un signal pilote e(t), dont il faut reproduire la forme à forte puissance est fourni par un circuit 1. Le signal est appliqué par la connexion $E_1$, d'une part à un circuit à découpage 2 et d'autre part, à des circuits à créneau 3.1,3.2,...,3.n.

4

Un circuit 20 fournit des tensions de seuils $S_1, S_2, \ldots S_n$ qui commandent respectivement les commutations des circuits 3.1, 3.2, ..., 3.n. Chacun de ces circuits à créneau ainsi que le circuit à découpage 2 contient une alimentation continue. Les courants fournis par les circuits 2, 3.1, 3.2, ..., 3.n s'ajoutent dans la charge 4.

La figure 2 montre un exemple de réalisation du générateur, suivant l'invention. Il comprend le circuit à découpage 2 ainsi que le circuit de commutation à créneau 3. Sur cette figure on n'a représenté qu'un seul circuit de commutation à créneau ..

Le circuit 20 fournit la tension de seuil positive S, ainsi que la tension de seuil négative -S. La tension du signal de référence e(t) généré par le circuit 1 de la figure 1 est appliqué entre l'entrée $E_1$ et la masse M. Les comparateurs 21 et 22 comparent la tension pilote e(t) aux seuils S et -S, fournissant respectivement les signaux binaires $R_2$ et $R_4$. On aura ainsi $R_2 = 1$ si e(t)<S et $R_4 = 1$ si e(t)>-S. Les signaux binaires $R_2$ et $R_4$ sont appliqués à des inverseurs 23 et 24 fournissant les signaux binaires $R_1 = \overline{R}_2$ et $R_3 = \overline{R}_4$.

Les 4 éléments actifs de commutation $I_1$, $I_2$, $I_3$ et $I_4$ qui sont préférentiellement des transistors fonctionnant en régime de commutation, reçoivent respectivement les signaux $R_1$, $R_2$, $R_3$ et $R_4$ ; ainsi l'élément actif $I_1$ deivent conducteur s'il reçoit sur sa base un signal $R_1=1$.

Une alimentation (non représentée) fournit la tension continue entre les entrées $V^+$ et $V^-$. Les émetteurs des transistors $I_1$ et $I_3$ sont reliés à l'entrée $V^+$ et les collecteurs des transistors $I_2$ et $I_4$ à l'entrée $V^-$. Des diodes 25 et 26 sont placées en parallèle entre collecteurs et émetteurs des transistors $I_2$ et $I_4$. Les diodes sont conductrices dans le sens collecteur·

5

vers émetteur.

Le circuit à découpage 2 comprend suivant l'invention les mêmes éléments que le circuit à créneau, notamment les éléments actifs $J_1$, $J_2$, $J_3$ et $J_4$, les diodes 34 et 35, les comparateurs 27 et 28, ainsi que les inverseurs 29 et 30. La charge 4 est reliée par le conducteur 203 en N au collecteur de l'élément actif $I_3$ et à l'émetteur de l'élément actif $I_4$. Cette charge est reliée d'autre part par le conducteur 204 et l'élément de self-induction 33 en O à l'émetteur de l'élément actif $J_2$ et au collecteur de l'élément actif $J_1$. Le point commun P de l'émetteur du transistor $J_4$ et du collecteur du transistor $J_3$ est relié au point commun M de l'émetteur du transistor $I_4$ et du collecteur $I_3$.

Une tension de contre-réaction aux bornes de la self-induction 33 est ramenée à l'entrée $E_2$ par l'intermédiaire de la résistance 32. A cette entrée $E_2$ se trouve appliquée en plus, la tension de référence e(t), par l'intermédiaire de la résistance 31.

C'est la tension en $E_2$, $e_2(t)$, qui est comparée à la tension de la masse M dans les comparateurs 27 et 28. Ainsi si $e_2(t) < 0$ le comparateur 27 fournit le signal binaire $Q_2 = 1$ et par l'inverseur 29, $Q_1 = 0$. Si $e_2(t) > 0$ le comparateur 28 fournit le signal binaire $Q_4 = 1$ et par l'inverseur $Q_3 = 0$. Les signaux binaires $Q_1$, $Q_2$, $Q_3$ et $Q_4$ commandent les transistors $J_1, J_2, J_3$ et $J_4$.

Le circuit de découpage reçoit une tension continue entre les entrées $W^+$, sur les émetteurs des transistors $J_1$ et $J_3$, et $W^-$ sur les collecteurs des transistors $J_2$ et $J_4$.

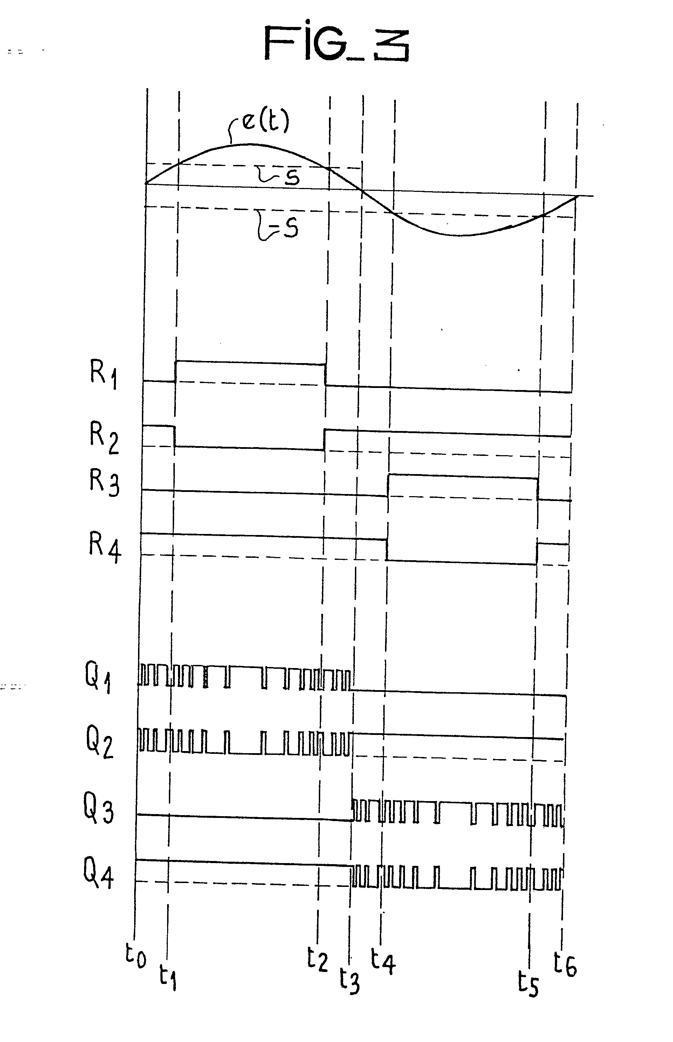

La figure 3 montre les signaux de commutation du montage de la figure 2. Pour simplifier on a pris un signal pilote e(t) sinusoïdal de période T, $t_0$ étant pris pour origine des temps. Dans l'intervalle $t_0$ à $t_1$,

6

les transistors $I_2$ et $I_4$ conduisent tandis que les transistors $I_1$ et $I_3$ sont bloqués, aucun courant ne peut circuler. Lorsque e(t) atteint le seuil S au temps $t_1$, $R_1$ et $R_2$ deviennent respectivement égaux à 1 et à 0 entraînant la conduction du transistor $I_1$ et le blocage du transistor $I_2$, un courant $i_3$ fourni par la source de pôles $V^+$ et $V^-$ va circuler dans la charge dans le sens M vers N dans l'intervalle $t_1$ à $t_2$. Puis lorsque e(t) atteint de nouveau le seuil S au temps $t_2$ , les transistors $I_1$ et $I_2$ deviennent respectivement bloqué et conducteur et le courant est coupé.

De même pendant l'alternance négative de e(t), le circuit 3 fournit un courant $i_3$ en sens opposé dans l'intervalle $t_4$ à $t_5$ pendant lequel e(t)<-S.

Le circuit à découpage 2 fournit à la charge de sortie 4 des impulsions de la tension d'alimentation, dont la durée est modulée en fonction de la valeur instantanée de l'amplitude e(t) du signal pilote. La tension de référence qui est appliquée aux comparateurs 27 et 28 étant nulle, immédiatement après l'instant $t_o$ le comparateur 27 fournit le signal $Q_1 = 1$ entraînant la conduction de l'élément $J_1$ et le blocage de l'élément $J_2$, ($Q_2 = 0$) . Le courant fourni  vers la charge de sortie croît exponentiellement avec une constante de temps qui est imposée par la self-induction 33 et la résistance de la charge 4. La tension en contre-réaction au signal pilote et la constante de temps sont choisies pour que cette contre-réaction produise une tension décroissante au niveau de l'entrée $E_2$ des comparateurs. De la sorte, lorsque cette tension devient inférieure à zéro, le comparateur fournit les signaux entraînant le blocage de $J_1$ ($Q_1 = 0$) et la conduction de $J_2$ ($Q_2 = 1$).

La tension en sortie croît alors à nouveau pour redécroître ensuite entraînant un nouveau cycle de conduction-blocage des éléments $J_1$ et $J_2$ mais dans un inter- valle de temps plus grand que le précédent du fait que l'amplitude du signal pilote croît moins rapidement.

On obtient ainsi entre les instants $t_o$ et $t_1$, des durées de conduction qui augmentent jusqu'à ce que le circuit à créneau soit activé à l'instant $t_1$, ajoutant dans la charge 4 une tension égale à sa tension d'alimentation. Ensuite, le processus décrit précédemment se répète de sorte que la tension aux bornes O et P du circuit à découpage 3 est formée de créneaux dont la largeur varie proportionnellement à l'amplitude du signal pilote entre les instants $t_o$ et $t_1$, $t_2$ et $t_3$ tandis qu'elle varie proportionnellement à la différence entre cette amplitude et la tension de seuil S dans l'intervalle $t_1$ et $t_2$.

Lorsque la tension du signal pilote devient négative, le fonctionnement reste identique, les éléments $J_1$ et $J_2$ étant respectivement bloqué et conducteur tandis que les éléments $J_3$ et $J_4$ sont rendus alternativement conducteurs comme décrit précédemment pour les éléments $J_1$ et $J_2$.

Lorsque le circuit à découpage est en fonction tandis que le circuit à créneau ne l'est pas, ce dernier doit présenter aux bornes M et N une impédance nulle. Ce résultat est obtenu grâce aux deux diodes 25 et 26 en parallèle sur les éléments $I_2$ et $I_4$ qui étant conducteurs forment respectivement avec les diodes 26 et 25 deux boucles conductrices. De même lorsque le circuit à créneau est en fonction tandis que le circuit à découpage ne l'est pas, le même résultat est obtenu aux deux bornes O et P grâce aux deux diodes 34 èt 35.

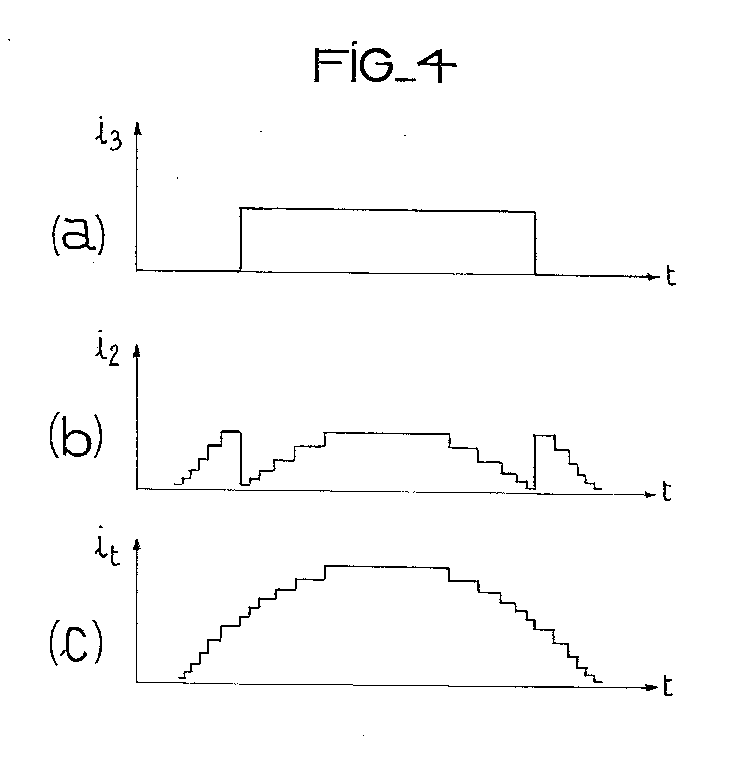

La figure 4 représente schématiquement les courants fournis dans la boucle de sortie 203 par le circuit à créneau $i_3$, (fig.4a) et le circuit à découpage $i_2$ (fig.4b), de manière à reproduire la tension sinusoïdale $i_4$ (fig.4c). L'allure du courant dû au

8

circuit à découpage figurée schématiquement en 4b tient compte de l'intégration produite par la self-induction 33 et la charge 4. Notons que si l'amplitude du signal pilote n'atteint pas le seuil de tension S, seul le circuit à découpage est en fonction.

Lorsque le générateur comporte plusieurs circuits à créneau le nombre de circuits en fonction à un moment donné, dépend de l'amplitude du signal pilote à ce moment et que lorsque tous les circuits fonctionnent, le générateur fournit la puissance maximale.

Suivant une variante de l'invention, les sorties M, N du circuit à créneau et O, P du circuit à découpage sont reliés chacun aux enroulements primaires de transformateurs dont les enroulements secondaires sont en série dans le circuit de la charge 4.

On a décrit ainsi un générateur de grande puissance à bon rendement. En effet, chaque circuit à créneau possède un très bon rendement, de l'ordre de 90 %, à cause du nombre de commutations réduit qu'il met en oeuvre. Ainsi pour un signal dont l'amplitude au cours d'une demi-période ne présente qu'un seul maximum, ce qui est souvent le cas, le nombre de commutations d'un élément est égal à 2 pendant cette demi-période. Par conséquent, le générateur possède un très bon rendement à puissance maximale, d'autant plus élevé que le nombre de circuits à créneau est grand. Ce rendement est obtenu avec un taux de distorsion réduit, dû à la présence du circuit à découpage fonctionnant avec une fréquence de découpage élevée. De plus la modulation du signal sortie est aisée, le fonctionnement des circuits à créneau s'arrêtant successivement lorsque l'amplitude du signal diminue et le fonctionnement du circuit à découpage garantissant un taux de distorsion encore faible même si tous les circuits à créneau sont arrêtés.

Expérimentalement, on a montré avec un générateur comportant trois circuits à créneau combinés avec un circuit à découpage, que le signal de sortie peut être atténué de 20dB environ dans les mêmes conditions de qualité , qu'avec un générateur comportant un seul circuit à découpage, dont le signal de sortie ne serait atténué que de 10dB. En outre, un circuit peut tomber en panne sans affecter le fonctionnement des autres. Enfin, chaque circuit peut être muni d'une contre-réaction de manière qu'il soit possible de faire fonctionner indifféremment un circuit soit en régime de découpage, soit en régime de créneau : le générateur devient donc reconfigurable en cas de panne d'un circuit pour assurer encore un fonctionnement dans de bonnes conditions.

10

REVENDICATIONS

1 - Générateur de signaux électriques (1) fournissant une puissance pouvant atteindre plusieurs dizaines de kilowatts à une charge (4), piloté par un signal de forme e(t), t étant le temps, le courant dans la charge (4) étant sensiblement proportionnel au signal pilote e(t), e(t) pouvant être une sinusoïde de fréquence pouvant atteindre plusieurs dizaines de kHz et comportant un circuit (2) fournissant à la charge (4) des impulsions rectangulaires de largeur variable, ce circuit étant appelé circuit à découpage, caractérisé par le fait que ce générateur comporte en combinaison avec le circuit à découpage n circuits appelés circuits à créneau, (3.1,3.2,...,3.n),où n est un entier supérieur ou égal à 1, chacun des circuits à créneau fournissant des créneaux de courant à la charge (4) et qu'un circuit (20) fournit des tensions de seuil réglables $S_1$, $S_2$,...,$S_n$, que des comparateurs comparent le signal e(t) aux seuils $S_1$, $S_2$,...,$S_n$, commandant la conduction et le blocage d'éléments actifs dans les circuits à créneau (3.1, 3.2,..., 3.n) et que des sources de tension continue dans chacun de ces circuits fournissent des courants à la charge (4) dans un sens positif, si e(t)>$S_i$ et un courant dans le sens négatif si e(t)>$S_i$ et un courant dans le sens né- gatif si e(t)<-$S_i$ et que le circuit à découpage (2) fournit à la charge des impulsions de courant de largeur proportionnelle à la différence du signal pilote et d'un signal égal à la somme des tensions de seuil des circuits à créneau (3.1, 3.2,...,3.n) en fonction.

2 - Générateur de signaux électriques suivant la revendication 1, caractérisé par le fait que chacun des circuits à créneau (3) comprend quatre commutateurs à éléments actifs ($I_1$, $I_2$, $I_3$ et $I_4$) formant un circuit en pont dont les sommets d'une diagonale sont connectés à une alimentation continue $V^+$ et $V^-$ et dont les sommets M et N de l'autre diagonale sont connectés à la charge, que les diodes (25, 26) sont placées en parallèle sur les commutateurs $I_2$ et $I_4$ le sens passant étant de la sortie $V^-$ aux points M et N, qu'un premier comparateur (21) recevant le signal e(t) et la tension de seuils fournit un signal de commande binaire $R_2$ commandant le commutateur $I_2$, un signal $R_1$ fourni par un inverseur recevant le signal $R_2$ commande le commutateur $I_1$, un deuxième comparateur (22) recevant le signal e(t) et la tension de seuil -S fournit de même avec un deuxième inverseur (24) les signaux de commandes binaires $R_3$ et $R_4$ des commutateurs $I_3$ et $I_4$.

3- Générateur de signaux électriques suivant la revendication 2, caractérisé par le fait que le circuit à découpage (2) comprend quatre commutateurs $J_1$, $J_2$, $J_3$ et $J_4$ montés de façon analogue aux commutateurs $I_1$, $I_2$, $I_3$ et $I_4$, qu'une sortie O du circuit à découpage est reliée à la charge par intermédiaire d'une self-induction (33), que des comparateurs (27, 28) et des inverseurs (29,30) fournissent les signaux de commande $Q_1$, $Q_2$, $Q_3$ et $Q_4$ des commutateurs $J_1$, $J_2$, $J_3$ et $J_4$, que les bornes négatives du troisième comparateur (27) et la borne positive du quatrième comparateur (28) sont reliées à la tension e(t) où est ramenée une contre-réaction par la tension aux bornes de la self-induction (33) les deux autres bornes des comparateurs étant reliées à la tension nulle de la masse (M).

4 - Générateur suivant la revendication 1, caractérisé par le fait que les bornes de sortie de chaque circuit à créneau (3.1, 3.2, ... , 3.n) ainsi que du circuit à découpage (2) sont reliés à des enroulements primaires de transformateurs et que les enroulements secondaires de tous ces transformateurs sont en série avec la charge (4)

# FIG_1

# FIG_2

# FIG_3

FIG_4

(a)

(b)

(c)

**RAPPORT DE RECHERCHE EUROPEENNE**

Office européen des brevets

Numéro de la demande

EP 80 40 1809

| Catégorie | DOCUMENTS CONSIDERES COMME PERTINENTS Citation du document avec indication, en cas de besoin, des parties pertinentes | Revendication concernée |
|---|---|---|
| | FR - A - 2 349 231 (THOMSON-CSF) <br> * page 1, ligne 30 - page 9, ligne 14; figures 1,2,4,6 * | 1-4 |
| | -- | |
| | FR - A - 2 419 610 (CIT-ALCATEL) <br> * page 1, ligne 1 - page 9, ligne 27; figure 1 * | 1-3 |
| | -- | |
| | GB - A - 2 018 057 (EXXON RESEARCH) <br> * page 1, ligne 56 - page 6, ligne 18; figure 9 * | 1-3 |
| | -- | |
| A | FR - A - 2 344 171 (CIT-ALCATEL) <br> * page 1, ligne 1 - page 9, ligne 40; figures 1,3 * | 1,3 |
| | -- | |
| A/D | US - A - 3 581 212 (McMURRAY) <br> * colonne 1, ligne 1 - colonne 10, ligne 4; figures 2,3,8 * | 1,2,4 |
| | -- | |
| A/D | TOUTE L'ELECTRONIQUE, janvier-février 1968 <br> PARIS (FR) <br> D. PASQUIER: "Les amplificateurs classe D", pages 31-36. <br> * en entier * | 1 |
| | ------ | |

**CLASSEMENT DE LA DEMANDE (Int. Cl. 3)**

H 02 M 7/537
H 03 F 3/217
H 03 B 11/10

**DOMAINES TECHNIQUES RECHERCHES (Int. Cl. 3)**

H 03 B 5/00
11/10
H 03 F 3/217
1/06
H 02 M 7/537
G 01 S 15/00
H 02 M 7/48

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 09-04-1981 | DHONDT |

OEB Form 1503.1 06.78